# EUROPÄISCHE PATENTSCHRIFT

(11) **EP 2 166 915 B1**
(45) Veröffentlichungstag und Bekanntmachung des Hinweises auf die Patenterteilung: **31.10.2012**
(21) Anmeldenummer: 08774667.3
(22) Anmeldetag: 02.07.2008
(51) Int. Cl.: G01R 33/07, D06F 37/42, G01D 3/08, G01D 5/14, A47L 15/42

(54) **HAUSHALTSGERÄT MIT SELBSTDIAGNOSEFÄHIGER TÜRSCHLOSSSTELLUNGS- ERFASSUNGSEINRICHTUNG**
DOMESTIC APPLIANCE WITH A SELF-DIAGNOSING DOOR LOCK POSITION DETECTION DEVICE
APPAREIL DOMESTIQUE DOTE D'UN DISPOSITIF DE DETECTION DE LA POSITION D'UNE FERMETURE DE PORTE A AUTO-DIAGNOSTIC

(30) Priorität: 09.07.2007 DE 102007031886
(43) Veröffentlichungstag der Anmeldung: 31.03.2010
(73) Patentinhaber: BSH Bosch und Siemens Hausgeräte GmbH, 81739 München (DE)
(72) Erfinder: CHRISTMANN, Jens, 89522 Heidenheim (DE); SCHWEIER, Peter, 86735 Forheim (DE)
(86) Internationale Anmeldenummer: PCT/EP2008/058533
(87) Internationale Veröffentlichungsnummer: WO 2009/007290

(56) Entgegenhaltungen:
- EP-A- 1 498 796
- WO-A-02/27344
- WO-A-2006/063684
- DE-A1- 2 938 659
- DE-A1- 3 539 199
- DE-A1- 19 521 293
- DE-A1-102005 017 870
- GB-A- 2 133 455
- US-A- 4 114 194

## Beschreibung

Die Erfindung betrifft ein Haushaltsgerät nach dem Oberbegriff des Patentanspruchs 1.

Die Erfassung der Türschlossstellung bei einem Haushaltsgerät ist notwendig, um einen sicheren Betrieb des Haushaltsgerätes zu gewährleisten. Bspw. wird bei einem Geschirrspüler die Umwälzpumpe gestoppt, wenn die Tür nicht mehr geschlossen ist. Hierdurch sollen Verbrühungen durch herausspritzendes Wasser vermieden werden.

Bekannt ist, die Türschlossstellung mittels eines Reedschalters zu erfassen. Der Reedschalter umfasst in einem Schutzraum angeordnete, magnetisierbare Schaltkontakte, die durch einen externen Dauermagnet in eine Schließstellung oder Öffnungsstellung gebracht sind. Der Dauermagnet ist an einem beweglichen Schließteil des Türschlosses angeordnet. Wird nunmehr das Türschloss geöffnet, gelangt der Reedschalter aus dem Wirkungsbereich des Dauermagneten. Hierdurch wird der Reedschalter je nach Beschaltung geöffnet oder geschlossen und eine Veränderung des Stromkreises ist durch eine Überwachungsschaltung detektierbar.

Nachteilig bei derartigen Reedschaltern ist, dass Fehlfunktionen, bspw. durch Kurzschluss oder Unterbrechung hervorgerufen, als normale Betriebszustände interpretiert und ausgewertet werden und somit nicht erkannt werden.

Die GB 2 133 455 A sieht eine Verschlussvorrichtung für die Tür eines Haushaltsgeräts mit einer in eine Offen- und in eine Schließstellung schwenkbaren Gabelfalle vor. Diese weist einen einem feststehenden Riegel am Gerätegehäuse zugeordneten gabelförmigen Endabschnitt und einen türinnenseitigen Endabschnitt auf, welcher mit einer auf einem feststehenden Bolzen längsgeführten, schwenkbaren Schubstange als Kniehebelgetriebe zusammenwirkt. Auf der Schubstange sitzt eine Druckfeder, die sich einerseits gegen den Bolzen und andererseits gegen den türinnenseitigen Endabschnitt der Gabelfalle abstützt. Es ist ein im Stromkreis des Haushaltsgeräts liegender Schalter vorgesehen, der bei in die Offenstellung verschwenkter Gabelfalle über einen Ansatz der Schubstange den Schalter betätigt und den Stromkreis des Haushaltsgeräts unterbricht.

Ein Haushaltsgerät gemäß dem Oberbegriff von Anspruch 1 ist durch EP 1498796 offenbart.

Fur die Betatigung einer Türverschlusseinncniung zwischen einer Schließ- und einer Öffnungsstellung ist ein Thermoaktuator vorgesehen. Dieser kann einen Schlitten, an dem an einer festgelegten Längsposition ein Indikator vorgesehen ist, bewegen. Dabei kann der Indikator durch ein ferromagnetisches Material gebildet sein. Seine Position kann mittels eines Hall-Sensors erfasst werden.

Der Erfindung liegt daher die Aufgabe zugrunde, ein Haushaltsgerät mit Selbstdiagnosefähigkeit bereitzustellen.

Die Erfindung geht aus von einem Haushaltgerät, insbesondere wasserführendes Haushaltsgerät, wie bspw. einer Haushalts-Geschirrspülmaschine, die wenigstens eine Tür aufweist, mit der ein Behandlungsraum des Haushaltsgeräts geöffnet und geschlossen werden kann. Ferner sind Türstellungserfassungsmittel zum Erfassen einer geöffneten oder geschlossenen Türstellung vorgesehen.

Die Aufgabe der Erfindung wird dadurch gelöst, dass die Türstellungserfassungsmittel bei geöffneter und geschlossener Türstellung ein der Türstellung entsprechendes, insbesondere von Null abweichendes Signal, bereitstellen. Somit steht bei jeder Position der Tür ein Signal zur Verfügung, dessen Vorliegen anzeigt, dass die Türstellungserfassungsmittel funktionsfähig sind.

Vorzugsweise ist dabei vorgesehen, dass die Türstellungserfassungsmittel bei geöffneter und geschlossener Türstellung zu einander invertierte Signale bereitstellen. Dies erlaubt eine besonders einfache Signalverarbeitung zur Überprüfung der Funktionsfähigkeit durch invertieren eines der der beiden Signale sowie anschließende Überwachung auf Abweichungen hin.

Ferner ist erfindungsgemäß vorgesehen, dass die Türstellungserfassungsmittel mit einer Überwachungsschaltung zur Funktionsüberwachung verbunden sind, sodass die Funktionsfähigkeit der Türstellungserfassungsmittel permanent oder auch in Intervallen geprüft werden kann und insgesamt eine Selbstdiagnosefähigkeit gegeben ist.

Erfindungsgemäß ist vorgesehen, dass die Türstellungserfassungsmittel zur induktiven Erfassung ausgebildet sind. Analog sind unterschiedlichen Türstellungen verschiedene Induktivitäten zugeordnet.

Erfindungsgemäß ist dabei vorgesehen, dass die Türstellungserfassungsmittel wenigstens einen Permanentmagneten und einen Magnetschalter aufweisen, sodass die Vorrichtung einen einfachen Aufbau aufweist.

Ferner ist erfindungsgemäß vorgesehen, dass der Magnetschalter ein Hallsensor ist. Hierbei kann ausgenutzt werden, dass bei bekanntem Eingangssignal an einem Hallsensor an dessen Ausgang ein invertiertes Signal des Eingangssignals anliegt. Bei bekanntem Eingangssignal kann somit auf das zu erwartende Ausgangssignal geschlossen werden. Tritt dieses erwartete Ausgangssignal nicht ein, ist entweder das zu überwachende Türschloss geöffnet oder es liegt eine allgemeine Schaltungsstörung vor. Hierdurch lässt sich auf einfache Weise eine zusätzliche Sicherheitsfunktion integrieren.

Dabei ist vorzugsweise vorgesehen, dass die Tür mittels einer Schließeinrichtung in wenigstens einer Türstellung arretierbar ist, bspw. in Türstellung, bei der die Tür einen Behandlungsraum eines Haushaltsgeräts verschließt. Hierzu kann bspw. im Falle einer Haushaltsgeschirrspülmaschine ein so genanntes Aufreißschloss Verwendung finden, bei dem zum Öffnen einer Tür nur das Aufbringen einer Mindestkraft erforderlich ist, jedoch keine Schlüssel oder dergleichen. Dabei gewährleistet die Schließeinrichtung, dass die Tür auch während des Betriebs des Haushaltsgeräts geschlossen bleibt und nicht durch den im Behandlungsraum herrschenden Innendruck aufgedrückt wird, der bspw. durch Erwärmung der Luft im Behandlungsraum aufgebaut wird.

Hierbei ist vorzugsweise vorgesehen, dass das Türstellungserfassungsmittel eine Türschlossstellungs-Erfassungseinrichtung ist. Es wird also nicht die Position der Tür, sondern die Position eines Schließkeils eines Schlosses erfasst. Dies erlaubt einen besonders kompakten Aufbau, bei dem sowohl der Permanentmagnet als auch der Hallsensor in einer Türschlossstellungserfassungs-Einrichtung integriert sind. Ferner können der Permanentmagnet als auch der Hallsensor an der Tür oder dem Gehäuse des Haushaltsgeräts angeordnet werden.

Ferner ist vorzugsweise vorgesehen, dass durch Bewegen der Tür, insbesondere durch Schließen, der Hallsensor in den Wirkungsbereich des Permanentmagneten bringbar ist.

In einer bevorzugten Ausführungsform ist vorgesehen, dass die Überwachungsschaltung ein definiertes Signal erzeugt, das dem Hallsensor zugeführt wird und Ausgangsignale des Hallsensors auf Plausibilität überprüft werden.

Die Überwachungsschaltung umfasst erfindungsgemäß eine Vergleichsschaltung, die Ausgangsignale des Hallsensors mit einem Soll-Signal des Hallsensors vergleicht. Bei Vorliegen einer Abweichung von einem invertierten Eingangssignal des Hallsensors kann somit auf mangelnde Funktionsfähigkeit geschlossen werden.

Erfindungsgemäß ist vorgesehen, dass bei Abweichung von Ausgangsignalen des Hallsensors vom Soll-Signal ein Signal generiert wird. Dies Signal kann in einer Steuerung eines Haushaltsgeräts weiterverarbeitet werden und verschiedene Sicherheitsmassnahmen auslösen, wie bspw. das Abschalten von Pumpen wie der Umwalzpumpe oder das Abschalten der Heizung, wenn die Tür nicht geschlossen ist. Dabei kann es sich um ein optisches und/oder akustisches Alarmsignal handeln.

In bevorzugter Ausgestaltung der Erfindung ist vorgesehen, dass das am Eingang des Hallsensors anliegende definierte Signal ein Pulssignal, bspw. mit fester Taktfrequenz ist. Hierdurch lässt sich in besonders einfacher Weise durch einfache Umkehr dieses gepulsten Signals das invertierte Signal am Ausgang des Hallsensors abgleichen.

Dabei ist vorzugsweise vorgesehen, dass das definierte Signal ein Rechtecksignal ist.

Ferner ist vorzugsweise vorgesehen, dass das Haushaltsgerät ein Geschirrspüler ist.

Schließlich gehört zur Erfindung eine Türschlossstellungs-Erfassungseinrichtung für ein Haushaltsgerät.

Die Erfindung wird nachfolgend in einem Ausführungsbeispiel anhand der zugehörigen Zeichnungen näher erläutert. Es zeigen:
- Fig. 1: eine schematische Ansicht einer erfindungsgemäßen Schaltungsanordnung zur Überwachung der Stellung eines Türschlosses, und
- Fig. 2: ein Schaltbild der Schaltungsanordnung.

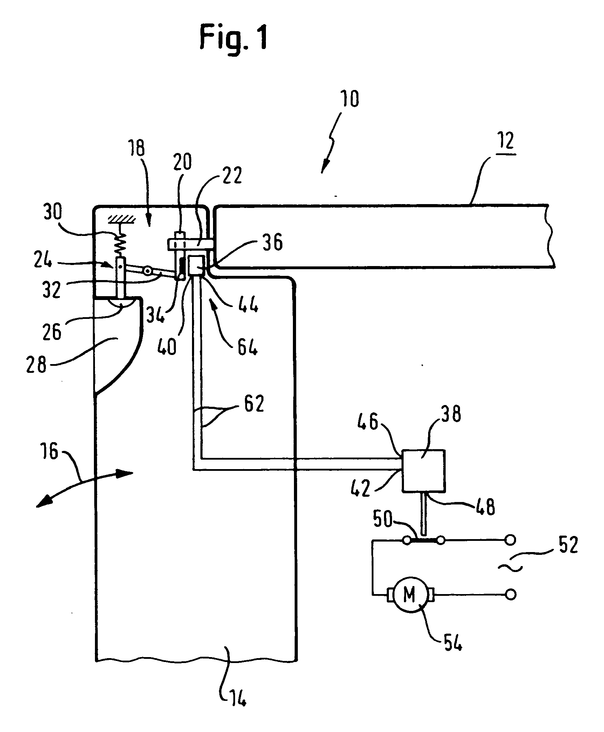

Fig. 1 zeigt schematisch einen Ausschnitt eines Geschirrspülers 10. Der Geschirrspüler 10 besitzt ein Gehäuse 12, das durch eine Tür 14 verschließbar ist. Die Tür 14 ist am Gehäuse 12 so angelenkt, dass diese entsprechend dem Doppelpfeil 16 öffnenbeziehungsweise schließbar ist. Aufbau und Wirkungsweise vom Geschirrspüler 10 sind allgemein bekannt, so dass im Rahmen der vorliegenden Beschreibung hierauf nicht näher eingegangen werden soll.

Die Tür 14 ist mittels einer Schließeinrichtung 18 am Gehäuse 12 arretierbar. Die Schließeinrichtung 18 umfasst einen Schließkeil 20, der in Eingriff mit einer Schließfalle 22 bringbar ist. Die Schließfalle 22 ist an dem Gehäuse 12 angeordnet und greift in eine entsprechende Öffnung (nicht dargestellt) der Tür 14 ein. Der Schließkeil 20 ist mittels einer Betätigungseinrichtung 24 bewegbar. Die Betätigungseinrichtung 24 umfasst ein Tastelement 26, das durch eine Griffmulde 28 innerhalb der Tür 14 erreichbar ist. Das Tastelement 26 ist gegen die Kraft eines Federelementes 30 verlagerbar, so dass über einen drehbar ge mein bekannt, so dass im Rahmen der vorliegenden Beschreibung hierauf nicht näher eingegangen werden soll.

Die Tür 14 ist mittels einer Schließeinrichtung 18 am Gehäuse 12 arretierbar. Die Schließeinrichtung 18 umfasst einen Schließkeil 20, der in Eingriff mit einer Schließfalle 22 bringbar ist. Die Schließfalle 22 ist an dem Gehäuse 12 angeordnet und greift in eine entsprechende Öffnung (nicht dargestellt) der Tür 14 ein. Der Schließkeil 20 ist mittels einer Betätigungseinrichtung 24 bewegbar. Die Betätigungseinrichtung 24 umfasst ein Tastelement 26, das durch eine Griffmulde 28 innerhalb der Tür 14 erreichbar ist. Das Tastelement 26 ist gegen die Kraft eines Federelementes 30 verlagerbar, so dass über einen drehbar gelagerten Kragarm 32 der Schließkeil 20 außer Eingriff mit der Schließfalle 22 bringbar ist beziehungsweise bei Zudrücken der Tür 14 automatisch durch die Kraft des Federelementes 30 in Eingriff mit der Schließfalle 22 bringbar ist. Der hier gezeigte schematische Aufbau der Schließeinrichtung 18 ist lediglich beispielhaft. Jede andere geeignete Ausführungsform ist möglich.

Ferner ist eine Türschlossstellungs-Erfassungseinrichtung 64 vorgesehen, die wenigstens einen Permanentmagneten 34 und einen als Magnetschalter dienenden Hallsensor 36 umfasst. Dabei ist der Permanentmagnet 34 an der Tür 14 angeordnet, während der Hallssensor 36 ortsfest am Gehäuse 12 befestigt ist.

Bei Öffnung der Schließeinrichtung 18 erfährt der Schließkeil 20 eine Bewegung. Am Schließkeil 20 ist der Permanentmagnet 34 angeordnet, dessen Wirkbereich sich bei geschlossener Tür 14 im Erfassungsbereich des Hallsensors 36 befindet. Der Hallsensor 36 ist mit einer Überwachungsschaltung 38 verbunden. Hierbei ist mittels Verbindungsleitungen 62 ein Eingang 40 des Hallsensors 36 mit einem Ausgang 42 der Überwachungsschaltung und ein Ausgang 44 des Hallsensors 36 mit einem Eingang 46 der Überwachungsschaltung 38 verbunden. Ein Schaltausgang 48 der Überwachungsschaltung 38 ist mit einem Schaltelement 50 eines Versorgungsspannungskreises 52 für einen Umwälzpumpenmotor 54 des Geschirrspülers 10 verbunden.

Die in Fig. 1 dargestellte Schaltungsanordnung zeigt folgende Funktion:
Während des bestimmungsgemäßen Einsatzes des Geschirrspülers 10 ist die Tür 14 verschlossen. Das heißt, der Schließkeil 20 greift in die Schließfalle 22 ein, so dass der Permanentmagnet 34 eine definierte Position in Bezug auf den Hallsensor 36 einnimmt. Wird nun während des Betriebes des Geschirrspülers 10 die Betätigungseinrichtung 24 vershentlich betätigt, verändert sich die Lage des Permanentmagneten 34 in Bezug auf den Hallsensor 36. Eine hiermit einhergehende Änderung der Hallspannung des Hallsensors 36 wird durch die Überwachungsschaltung 38 erfasst und ein Ausschaltsignal für den Umwälzpumpenmotor 54 generiert. Dies geschieht durch Ansteuerung des Schaltelements 50.

Die Überwachungsschaltung 38 beinhaltet gleichzeitig eine Selbstüberwachung des Hall-sensors 36. Hierzu liegt am Ausgang 42 der Überwachungsschaltung 38 ein definiertes Signal an, mit dem der Hallsensor 36 über seinen Eingang 40 gespeist wird. Am Ausgang 44 liegt dann ein invertiertes Signal dieses Eingangssignals an, das über den Eingang 46 der Überwachungsschaltung 38 zugeführt wird. Die Überwachungsschaltung 38 kann mittels einer Vergleichsschaltung 56 das Ist-Eingangssignal an der Überwachungsschaltung 38 mit dem erwarteten Soll-Eingangssignal vergleichen. Bei Abweichung liegt entweder eine Funktionsstörung des Hallsensors 36 oder eine Unterbrechung beziehungsweise ein Kurzschluss in den Verbindungsleitungen 62 zwischen Überwachungsschaltung 38 und Hallsensor 36 vor.

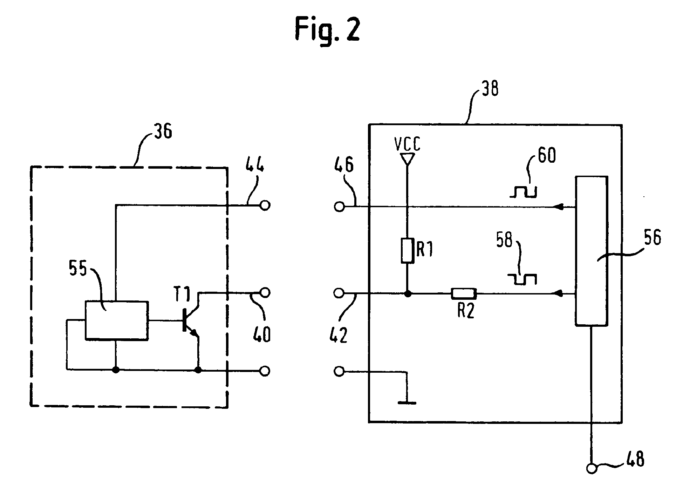

Anhand von Fig. 2 wird die Vergleichsschaltung 56 erläutert. Die Vergleichsschaltung 56 generiert einerseits das am Ausgang 42 der Überwachungsschaltung 38 anliegende Ausgangssignal 58 und empfängt andererseits das am Eingang 46 der Überwachungsschaltung 38 anliegende Eingangssignal 60. Das Ausgangssignal 58 wird über einen Spannungsteiler der Widerstände R1 und R2 auf den Ausgang 42 geführt und liegt somit am Eingang 40 des Hallsensors 36 an. Über einen Eingangstransistor T1, dessen Kollektor mit dem Eingang 40 verbunden ist, wird dieses Ausgangssignal 58 auf den sensitiven Chip 55 des Hallsensors 36 geführt.

Am Ausgang 44 des Hallsensors 36 liegt dann das invertierte Eingangssignal an, das über den Eingang 46 der Überwachungsschaltung 38 als Signal 60 der Vergleichsschaltung 56 zugeführt wird.

Im gezeigten Beispiel ist das Ausgangssignal 58 der Überwachungsschaltung 38 ein Rechtecksignal mit vorgegebener Taktfrequenz. Das Signal 60 ist dann - bei korrekter Betriebsweise - exakt das invertierte Signal des Signals 58. Das heißt, wenn das Signal 58 den Pegel LOW hat, hat das Signal 60 den Pegel HIGH, und wenn das Signal 58 den Pegel HIGH hat, hat das Signal 60 den Pegel LOW.

Über die Vergleichsschaltung 56 kann nunmehr entsprechend dem Signal 58 das Signal 60 dahingehend ausgewertet werden, ob dieses Ist-Signal 60 dem erwarteten Soll-Signal entspricht. Kommt es hier zu einer Abweichung zwischen dem erwarteten Signal und dem Ist-Signal 60, wird über die Vergleichsschaltung 56 auf den Ausgang 48 der Überwachungsschaltung 38 das Alarmsignal zur Unterbrechung des Versorgungsspannungskreises 52 (Fig. 1) generiert.

### Bezugszeichenliste

- 10: Geschirrspüler
- 12: Gehäuse
- 14: Tür
- 16: Öffnung oder Schließung der Tür
- 18: Schließeinrichtung
- 20: Schließkeil
- 22: Schließfalle
- 24: Betätigungseinrichtung
- 26: Tastelement / Taste
- 28: Griffmulde
- 30: Federelement
- 32: Kragarm
- 34: Permanentmagnet
- 36: Hallsensor
- 38: Überwachungsschaltung
- 40: Eingang des Hallsensors
- 42: Ausgang der Überwachungsschaltung
- 44: Ausgang des Hallsensors
- 46: Eingang der Überwachungsschaltung
- 48: Schaltausgang
- 50: Schaltelement
- 52: Versorgungsspannungskreis
- 54: Umwälzpumpenmotor
- 55: sensitiver Chip
- 56: Vergleichsschaltung
- 58: Ausgangssignal
- 60: Eingangssignal
- 62: Verbindungsleitungen
- 64: Türschlossstellungs-Erfassungseinrichtung

## Patentansprüche

1. Haushaltsgerät (10), insbesondere wasserführendes Haushaltsgerät (10), wenigstens aufweisend eine Tür (14) und zur induktiven Erfassung ausgebildete Türstellungserfassungsmittel zum Erfassen einer geöffneten oder geschlossenen Türstellung, wobei die Türstellungserfassungsmittel wenigstens einen Permanentmagneten (34) und einen Hallsensor (36) aufweisen und bei geöffneter und geschlossener Türstellung ein der Türstellung entsprechendes, insbesondere von Null abweichendes Signal, bereitstellen,
**dadurch gekennzeichnet, dass**
- die Türstellungserfassungsmittel mit einer Überwachungsschaltung (38) verbunden sind, die wenigstens zur Überprüfung der Funktionsfähigkeit der Türstellungserfassungsmittel ausgebildet ist,
- die Überwachungsschaltung (38) eine Vergleichsschaltung (56) umfasst, die Ausgangsignale des Hallsensors (36) mit einem Soll-Signal des Hallsensors (36) vergleicht und bei Abweichung der Ausgangsignale des Hallsensors (36) vom Soll-Signal ein Signal generiert, und
- eine Steuerung des Haushaltgeräts (10) das Signal weiterverarbeitet und in Abhängigkeit von dem Signal Sicherheitsmaßnahmen in Form eines Abschaltens einer Pumpe, insbesondere einer Umwälzpumpe, oder einer Heizung auslöst.

2. Haushaltsgerät nach Anspruch 1, **dadurch gekennzeichnet, dass** die Türstellungserfassungsmittel bei geöffneter und geschlossener Türstellung zu einander invertierte Signale bereitstellt.

3. Haushaltsgerät nach einem der vorherigen Ansprüche, **dadurch gekennzeichnet, dass** die Tür mittels einer Schließeinrichtung (18) in wenigstens einer Türstellung arretierbar ist.

4. Haushaltsgerät nach einem der vorherigen Ansprüche, **dadurch gekennzeichnet, dass** das Türstellungserfassungsmittel eine Türschlossstellungs-Erfassungseinrichtung (64) ist.

5. Haushaltsgerät nach einem der vorhergehenden Ansprüche, **dadurch gekennzeichnet, dass** durch Bewegen der Tür (14) der Hallsensor (36) in den Wirkungsbereich des Permanentmagneten (34) bringbar ist.

6. Haushaltsgerät nach einem der vorhergehenden Ansprüche, **dadurch gekennzeichnet, dass** die Überwachungsschaltung (38) ein vorgebbares Signal (52) erzeugt, das dem Hallsensor (36) zugeführt wird und Ausgangsignale des Hallsensors (36) auf Plausibilität überprüft werden.

7. Haushaltsgerät nach Anspruch 6, **dadurch gekennzeichnet, dass** das vorgebbare Signal (52) ein Pulssignal ist.

8. Haushaltsgerät nach einem der der Ansprüche 6 oder 7, **dadurch gekennzeichnet, dass** das vorgebbare Signal (52) ein Rechtecksignal ist.

9. Haushaltsgerät nach einem der vorherigen Ansprüche, **dadurch gekennzeichnet, dass** das Haushaltsgerät (10) ein Geschirrspüler ist.

## Claims

1. Domestic appliance (10), particularly water-conducting domestic appliance (10), at least comprising a door (14) and door setting detection means, which are constructed for inductive detection, for detecting an open or closed door setting, wherein the door setting detection means comprises at least one permanent magnet (34) and a Hall sensor (36) and in the case of an open and closed door setting provides a signal, particularly a signal differing from zero, corresponding with the door setting,
**characterised in that**
- the door setting detection means are connected with a monitoring circuit (38), which is constructed at least for checking the functional integrity of the door setting detection means,
- the monitoring circuit (38) comprises a comparison circuit (56) which compares output signals of the Hall sensor (36) with a target signal of the Hall sensor (36) and generates a signal if the output signals of the Hall sensor (36) differ from the target signal and
- a control of the domestic appliance (10) processes the signal and in dependence on the signal triggers safety measures in the form of switching-off of a pump, particularly a circulating pump, or of heating means.

2. Domestic appliance according to claim 1, **characterised in that** the door setting detection means in the case of open and closed door setting provides signals inverted relative to one another.

3. Domestic appliance according to one of the preceding claims, **characterised in that** the door is lockable in at least one door setting by means of a closing device (18).

4. Domestic appliance according to any one of the preceding claims, **characterised in that** the door setting detection means is a door lock setting detection device (64).

5. Domestic appliance according to any one of the preceding claims, **characterised in that** the Hall sensor (36) can be brought into the effective range of the permanent magnet (34) through movement of the door (14).

6. Domestic appliance according to any one of the preceding claims, **characterised in that** the monitoring circuit (38) generates a presettable signal (52) which is supplied to the Hall sensor (36) and output signals of the Hall sensor (36) are checked for plausibility.

7. Domestic appliance according to claim 6, **characterised in that** the presettable signal (52) is a pulse signal.

8. Domestic appliance according to one of claims 6 and 7, **characterised in that** the presettable signal (52) is a square-wave signal.

9. Domestic appliance according to any one of the preceding claims, **characterised in that** the domestic appliance (10) is a dishwasher.

## Revendications

1. Appareil ménager (10), notamment appareil ménager à circulation d'eau (10), présentant au moins une porte (14) et des moyens de détection de position de porte réalisés pour la détection inductive, destinés à détecter une position de porte ouverte ou fermée, les moyens de détection de position de porte présentant au moins un aimant permanent (34) et un capteur de Hall (36) et fournissant un signal correspondant à la position de la porte, notamment différent de zéro, lorsque la position de la porte est ouverte et fermée,
**caractérisé en ce que**
- les moyens de détection de position de porte sont connectés à un circuit de surveillance (38) qui est réalisé au moins pour la vérification de la fonctionnalité des moyens de détection de position de porte,
- le circuit de surveillance (38) comprend un circuit de comparaison (56) qui compare des signaux de sortie du capteur de Hall (36) à un signal théorique du capteur de Hall (36) et, en cas d'écart des signaux de sortie du capteur de Hall (36) par rapport au signal théorique, génère un signal, et
- une commande de l'appareil ménager(10) traite le signal et, en fonction du signal, déclenche des mesures de sécurité sous forme d'une mise hors fonction d'une pompe, notamment d'une pompe de circulation, ou d'un chauffage.

2. Appareil ménager selon la revendication 1, **caractérisé en ce que** les moyens de détection de position de porte, lorsque la porte est en position ouverte et fermée, fournissent des signaux invertis les uns par rapport aux autres.

3. Appareil ménager selon l'une quelconque des revendications précédentes, **caractérisé en ce que** la porte est blocable dans au moins une position de porte au moyen d'un dispositif de fermeture (18).

4. Appareil ménager selon l'une quelconque des revendications précédentes, **caractérisé en ce que** le moyen de détection de position de porte est un dispositif de détection de position de la serrure de porte (64).

5. Appareil ménager selon l'une quelconque des revendications précédentes, **caractérisé en ce que** le capteur de Hall (36) peut être amené dans la zone active de l'aimant permanent (34) en raison du mouvement de la porte (14).

6. Appareil ménager selon l'une quelconque des revendications précédentes, **caractérisé en ce que** le circuit de surveillance (38) génère un signal prédéfinissable (52) qui est amené au capteur de Hall (36) et **en ce que** des signaux de sortie du capteur de Hall (36) sont vérifiés quant à leur plausibilité.

7. Appareil ménager selon la revendication 6, **caractérisé en ce que** le signal prédéfinissable (52) est un signal d'impulsion.

8. Appareil ménager selon la revendication 6 ou 7, **caractérisé en ce que** le signal prédéfinissable (52) est un signal rectangulaire.

9. Appareil ménager selon l'une quelconque des revendications précédentes, **caractérisé en ce que** l'appareil ménager (10) est un lave-vaisselle.
